# EUROPEAN PATENT APPLICATION

(11) **EP 2 253 446 A1**
(43) Date of publication of application: **24.11.2010**
(21) Application number: 09707840.6
(22) Date of filing: 06.02.2009
(51) Int. Cl.: B29C 45/37, G01R 33/09

(54) **INJECTION MOLDED ARTICLE AND MAGNETIC SENSOR**

(30) Priority: 06.02.2008 JP 2008025840
(71) Applicant: Murata Manufacturing Co. Ltd., Kyoto 617-8555 (JP)
(72) Inventor: SHINMURA, Koji, Nagaokakyo-shi Kyoto 617-8555 (JP); TOMAKI, Kenji, Nagaokakyo-shi Kyoto 617-8555 (JP); NAKAMURA, Munehisa, Nagaokakyo-shi Kyoto 617-8555 (JP); UEDA, Masaya, Nagaokakyo-shi Kyoto 617-8555 (JP); NISHIWAKI, Toshiki, Nagaokakyo-shi Kyoto 617-8555 (JP)
(74) Representative: Lloyd, Patrick Alexander Desmond
(86) International application number: PCT/JP2009/052035
(87) International publication number: WO 2009/099173

(57) **Abstract**

An injection molded article that avoids differences in the amount of molding shrinkage among sites, that suppresses bow, and that is injection molded is provided. A case (1) is formed by injection molding of resin material in which long-fiber fillers (9) are distributed and includes a side plate (3, 4) and a bottom plate (2). The side plate (3, 4) and the bottom plate (2) are in substantially parallel with a mean orientation direction of the long-fiber fillers (9) therein. The side plate (3,4) is provided with orientation disturbing sections (8A) for partially displacing orientation directions of the long-fiber fillers (9) during injection molding. Deformation of the case (1) is adjustable by control on the orientation of the long-fiber fillers (9) using the orientation disturbing sections (8A).

## Description

### Technical Field

The present invention relates to injection molded articles formed by injection molding of resin material and to magnetic sensors for detecting magnetism of, for example, a magnetic pattern printed on paper currency.

### Background Art

Various magnetic sensors for identifying a detection target, such as paper currency or a bill on which a specific magnetic pattern is printed with magnetic ink, are in actual use.

A typical magnetic sensor includes a long-type case, a plurality of magneto-resistive elements (hereinafter referred to as MR elements), and a magnet (see, for example, Patent Documents 1 and 2). The case has an opening for accommodating the magnet, and is arranged such that a bottom plate faces paper currency and the longitudinal direction of the case is perpendicular to the conveying direction of the paper currency, The plurality of MR elements are arranged on the bottom plate of the case and sense a change in magnetic field (magnetic flux density) in their surroundings. The magnet is arranged in the opening of the case and applies a magnetic field to the MR elements and conveyed paper currency. The case is typically an injection molded article formed by injection molding of resin material, and in order to enhance the strength of the injection molded article, long-fiber fillers may be distributed as a filler in the resin material (see, for example, Patent Documents 3 and 4).
[Patent Document 1] Japanese Unexamined Patent Application Publication No. 5-332703
[Patent Document 2] Japanese Unexamined Patent Application Publication No. 2005-300228
[Patent Document 3] Japanese Unexamined Patent Application Publication No. 2002-86509
[Patent Document 4] Japanese Unexamined Patent Application Publication No. 6-91707

### Disclosure of Invention

### Problems to be Solved by the Invention

For an injection molded article having a shape in which an opening is disposed at a top surface side, like a long-type case used in a long-type magnetic sensor, because the quantity of resin material at a bottom surface side is large, the bottom plate may be shrunk more largely, so arch-shaped bow may exist as the whole case. Thus, for a magnetic sensor In which a sensing surface is disposed at a bottom plate side, if it is used as it is, there is a problem in that the sensing surface is bowed in a reverse arch shape in which the sensing surface is concave, a gap to a detection target is not uniform, and detection sensitivity degrades.

To address this, in order to avoid differences in the amount of molding shrinkage, a reduced (slimmed-down) section, where the thickness is reduced, made of a circular hole or a groove, may be present in the bottom surface. The provision of such a reduced section was considered to be able to suppress bow of an injection molded article by achieving balance in the amount of molding shrinkage. However, generally, there are design limitations on the location and shape of a reduced section and the number of reduced sections, so bow having a reverse arch shape in which the bottom pate of an injection molded article is concave may not be sufficiently suppressed.

in order to correct the shape of a bowed injection molded article, a correction process of adding a weight to the injection molded article under heating environment to correct the shape of the injection molded article may be performed. In that case, it is possible to decrease deformation of the injection molded article to a certain tolerance range, but there is a problem in that cost and time required for the correction process are increased.

It is an object of the present invention to provide an injection molded article that overcomes the foregoing problems, that avoids differences in the amount of molding shrinkage among sites, that suppresses bow, and that is injection-molded and to provide a magnetic sensor that can make a gap between a sensing surface and a detection target uniform by suppression of bow of a case and decrease degradation in detection sensitivity.

### Means for Solving the Problems

An injection molded article according to the present invention is formed by injection molding of resin material in which a plurality of long-fiber fillers are distributed. The injection molded article has a case shape and includes a bottom portion and a side portion. The side portion is provided with an orientation disturbing section for partially displacing orientation directions of the long-fiber fibers during injection molding.

One example of the injection molded article can have a case shape or a U shape in cross section. Deformation of the injection molded article having such a configuration can be adjusted by control on the orientation of the long-fiber fillers. For example, like an injection molded article having a case shape, even for an injection molded article having as a configuration in which, if orientation of long-fiber fillers is not controlled, resin material is bowed concavely with respect to a bottom portion side, such bow can be decreased by optimal control on the orientation of the long-fiber fillers.

The present inventors reasoned that bow of an injection molded article having a case shape resulted from not only a shrinkage factor based on an external shape (for example, the amount of molding shrinkage increased with an increase in the amount of resin material and the difference in the amount of molding shrinkage led to bow) but also an orientation factor occurring depending on the degree of flow orientation of longs-fiber fillers distributed in the resin and conceived of the creation of the present invention.

Traditionally, for an injection molded article having a case shape, in particular, for a long-type injection molded article, which is long in one direction, it is known that a difference in shrinkage between an opening portion and a bottom portion caused by hardening of resin during injection molding causes the bottom portion to shrink toward the center of the injection molded article in its longitudinal direction and thus the injection molded article is bowed concavely with respect to the bottom portion, that is, as the whole case, the injection molded article is bowed in a reverse arch shape. As a result of intensive studies, the present inventors have found that the use of resin in which long-fiber fillers are distributed and the provision of an orientation disturbing section for displacing the orientation of the long-fiber fillers to a side portion of an injection molded article having a case shape causes the bottom portion of the injection molded article to be bowed convexly, that is, in an arch shape as the whole case and have found that the reverse arch bow and the arch bow can cancel each other out.

Here, it is known that the bottom portion is provided with a reduced section However, simply providing the reduced section to the bottom portion cannot offer sufficient advantageous effects of an orientation factor and cannot sufficiency decrease reverse arch bow. When the side portion is provided with an orientation disturbing section (e.g., reduced section), because the thickness of the side portion is locally decreased, the reverse arch bow may be considered to be facilitated. However, then the orientation disturbing section is disposed on the side portion so as to disturb the injection direction, that is, the orientation directions of the long-fiber fillers, the point that bow was able to occur in a direction opposite to the direction of reverse arch bow of the bottom portion is a new finding.

For example, if the thickness of the side portion is thinner than the thickness of the bottom portion, the amount of molding shrinkage in the bottom portion is apt to be large. However, an increase in the molding shrinkage in the side portion by the orientation disturbing section enables balance to the molding shrinkage in the bottom portion, and this can suppress bow of the injection molded article, so the present invention is effective.

When the orientation disturbing section is configured to have a shape in which it is depressed or projects partially in a vertical direction with respect to the mean orientation direction of the long-fiber fillers, the orientation directions of the long-fiber fibers during injection molding can be easily displaced from the mean orientation direction.

When the reduced section is provided to the bottom portion aside from the orientation disturbing section provided to the side portion, because an equivalent thickness of the bottom portion is small, a shrinkage factor can be further decreased, so the amount of molding shrinkage of the bottom portion can be further suppressed.

A magnetic sensor according to the present invention includes a case, a plurality of magneto-resistive elements, and a magnet. The case is the foregoing injection molded article. The plurality of magneto-resistive elements are arranged on a surface of the bottom portion that is opposite to an opening of the case and sense a change in magnetic field in their surroundings. The magnet is accommodated in the opening of the case and applies a magnetic field to the surroundings of the plurality of magneto-resistive elements.

Accordingly, a gap between a sensing surface and a detection target can be made uniform, and degradation in detection sensitivity can be decreased.

### Advantages

With the injection molded article according to the present invention, the orientation disturbing section is provided to the side portion, the orientation of the long-fiber fillers is displaced by the orientation disturbing section, and the amount of molding shrinkage in the side portion in their surroundings is increased, so differences in the amount of molding shrinkage among sites can be avoided and bow of the injection molded article can be suppressed. With the magnetic sensor according to the present invention, a gap between a sensing surface and a detection target can be made uniform and degradation in detection sensitivity can be decreased.

### Brief Description of Drawings

[Fig. 1] Fig. 1 is perspective views of a case according to a first embodiment,
[Fig. 2] Fig. 2 is partial perspective views that illustrate other configuration examples of an orientation disturbing section of the case.
[Fig. 3] Fig. 3 is partial perspective views that illustrate other configuration examples of the orientation disturbing section of the case.
[Fig. 4] Fig. 4 is a schematic side view of a magnetic sensor according to a second embodiment.
[Fig. 5] Fig. 5 is an exploded view of the magnetic sensor.
[Fig. 6] Fig. 6 is an exploded view of a case of the magnetic sensor.
[Fig. 7] Fig. 7 illustrates results of actual measurement.

### Reference Numerals

- 1: case
- 2: bottom plate (bottom portion)
- 3: right side plate (side portion)
- 4: left side plate (side portion)
- 5: rear plate
- 6: front plate
- 8A-8W: orientation disturbing sections
- 9: long-fiber filler
- 10: case
- 12: element accommodating section
- 13: magnet accommodating section
- 14A, 14B: orientation disturbing sections
- 15: pin through-hole
- 16: reduction hole
- 17: reduction groove
- 20: magneto-resistive element
- 30: long-type magnet
- 40: mold resin
- 50: terminal pin
- 100: magnetic sensor
- 101: paper currency
- 102: paper-currency guide plate

### Best Mode for Carrying Out the Invention

A configuration of an injection molded article according to a first embodiment is described below.

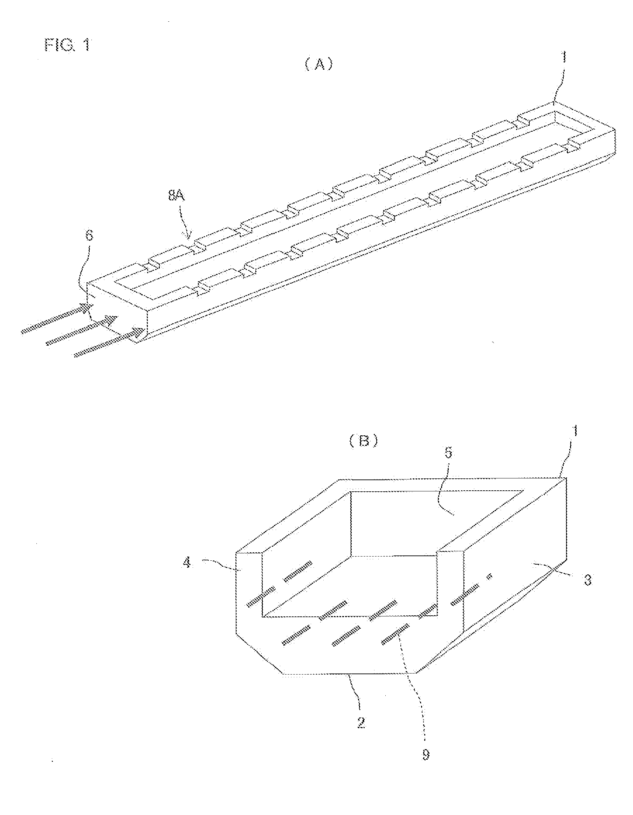

Fig. 1 is perspective views of a case 1 being an injection molded article; (A) of this drawing is a general perspective view, and (B) of this drawing is a perspective view of a partial cross section.

The case 1 includes a bottom plate 2 as a bottom portion, a right side plate 3 and a left side plate 4 as a side portion, a rear plate 5, and a front plate 6 and has a shape in which the length between the front plate 6 and the rear plate 5 is long and atop side above the bottom plate 2 is opened. In this way, due to the opening, during hardening in injection molding, resin material in the bottom plate 2 is easy to be shrunk by a shrinkage factor.

The case 1 is an injection molded article formed by injection molding of resin material in which long-fiber fillers 9 are distributed. The case 1 is formed by injection of resin material into a die from the front plate 6 side, which is illustrated in the left-hand near side in the drawing. Accordingly, for the bottom plate 2, the right side plate 3, and the left side plate 4, the flow orientation of the resin material is substantially along the longitudinal direction of the case 1 and the fiber orientation of the long-fiher fillers 9 is also substantially along the longitudinal direction of the case 1.

A plurality of orientation disturbing sections 8A is disposed at the upper surface of each of the right side plate 3 and the left side plate 4. Each of the orientation disturbing sections 81A is a lateral groove that is vertically depressed from the upper surface of the case and that has a rectangular cross section in the thickness direction. The orientation disturbing sections 8A are arranged in the longitudinal direction of the case 1. Because the orientation disturbing section 8 is disposed so as to displace the flow orientation of each of the resin material and the long-fiber fillers during injection molding, the flow orientation of each of the resin material and the long-fiber fillers is displaced, and the fiber orientation of the long-fiber fillers 9 in surroundings of the orientation disturbing section 8A is displaced from the longitudinal direction of the case 1. The fiber orientation of the long-fiber fillers 9 in the bottom plate 2 is along the longitudinal direction of the case 1. Because of this, the case 1 has strength distribution inside the article, and due to an orientation factor, the right side plate 3 and the left side plate 4 are shrinkable more easily than the bottom plate 2.

In this way, the shrinkage factor and the orientation factor are balanced, and bow in vertical directions in the drawing does not tend to occur in the case 1.

Examples of the resin material according to the present invention can be poly(p-phenylene sulfide) (PPS), polybutylene terephthalate (PBT), and polyethersulfone (PES), However, the resin material is not limited to these examples. The long-fiber fillers contained in the resin material described above can have any aspect ratio as long as it is larger than one. The "mean orientation direction of long-fiber fillers" used in the present invention indicates a mean of orientation directions of the orientated long-fiber fillers contained in the resin material and is substantially the same as the injection direction of injection molding.

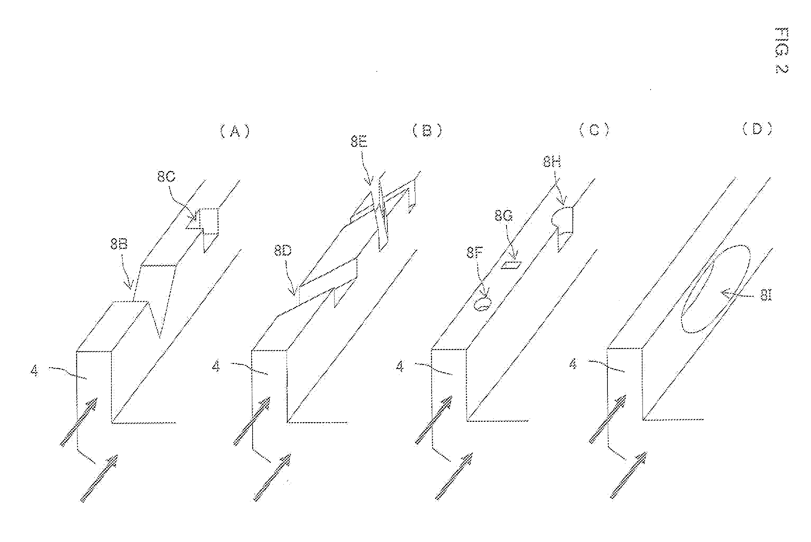

Fig. 2 is partial perspective views of the left side plate 4 and its surroundings to illustrate other configuration examples of the orientation disturbing section.

Orientation disturbing sections 8B and 8C are disposed at the upper surface of the left side plate 4 illustrated in (A) of this drawing. The orientation disturbing section 8B is a groove that has a triangular cross section In the thickness direction and that extends in the thickness direction. The orientation disturbing section 8C is a cubic cut disposed in the inner side of the opening of the case and in the upper surface side of the opening. The orientation disturbing sections 8B and 8C having the above-described shapes are perpendicular to the injection direction, so the fiber orientation of the long-fiber fillers in their surroundings is displaced from the longitudinal direction of the case.

Orientation disturbing sections 8D and 8E are disposed at the upper surface of the left side plate 4 illustrated in (B) of this drawing. The orientation disturbing section 8D is a groove that has a rectangular cross section in the thickness direction and that extends obliquely from the thickness direction. The orientation disturbing section 8E is a grating groove in which two oblique grooves are combined. The orientation disturbing sections 8D and 8E having the above-described shapes are perpendicular to the injection direction, so the fiber orientation of the long-fiber fillers in their surroundings is displaced from the longitudinal direction of the case.

Orientation disturbing sections 8F, 8G, and 8H are disposed at the upper surface of the left side plate 4 illustrated in (C) of this drawing. The orientation disturbing section 8F is a non-penetrating hole that has a circular cross section at the upper surface. The orientation disturbing section 8G is a non-penetrating hole that has a rectangular cross section at the upper surface. The orientation disturbing section 8H is a semi-cylindrical cut disposed in the inner side of the opening of the case and in the upper surface side of the opening. The orientation disturbing sections 8F, 8G, and 8H having the above-described shapes are perpendicular to the injection direction, so the fiber orientation of the long-fiber fillers in their surroundings is displaced from the longitudinal direction of the case.

An orientation disturbing section 8I passing through the left side plate 4 in the thickness direction is disposed at the left side plate 4 illustrated in (D) of the drawing. The orientation disturbing section 8I has an oblong hole shape. The orientation disturbing section 8I having the above-described shape is perpendicular to the injection direction, so the fiber orientation of the long-fiber fillers in its surroundings is displaced from the longitudinal direction of the case.

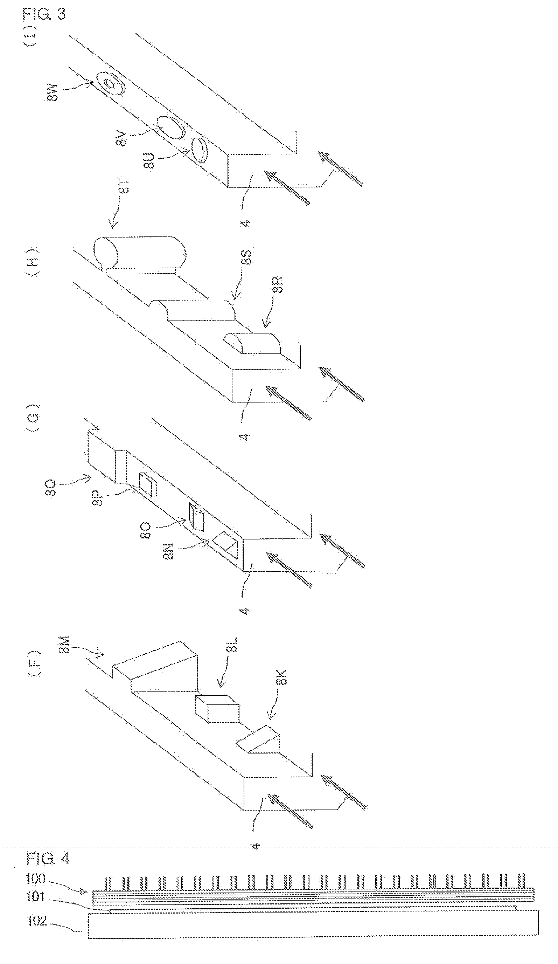

Fig. 3 is partial perspective views of the left side plate 4 and its surroundings to illustrate other configuration examples of the orientation disturbing section.

Orientation disturbing sections 8K, 8L, and 8M are disposed in adjacent areas of the opening at the left side plate 4 illustrated in (F) of this drawing. The orientation disturbing section 8K is a rib that has a triangular cross section and that extends from the bottom plate to near the center of the left side plate 4. The orientation disturbing section 8L is a rib that has a rectangular cross section and that extends from the bottom plate to near the center of the left side plate 4. The orientation disturbing section 8M is a rib that has a trapezoidal cross section and that extends from the bottom plate to near the upper surface of the left side plate 4. The long-fiber fillers attempt to flow into the orientation disturbing sections 8K, 8L, and 8M having the above-described shapes, so the fiber orientation of the long-fiber fillers in their surroundings is displaced from the longitudinal direction of the case.

Orientation disturbing sections 8N, 80, 8P, and 8Q are disposed at the upper surface of the left side plate 4 illustrated in (G) of this drawing. The orientation disturbing section 8N is a triangular pole boss that has a triangular cross section in the longitudinal direction. The orientation disturbing section 80 is a triangular pole boss that has a triangular cross section in the thickness direction. The orientation disturbing section 8P is a rectangular parallelepiped boss. The orientation disturbing section 8Q is a rectangular parallelepiped boss that has the same width in the thickness direction as the thickness of the left side plate 4. The long-fiber fillers attempt to flow into the orientation disturbing sections 8N, 8O, 8P, and 8Q having the above-described shapes, so the fiber orientation of the long-fiber filters in their surroundings is displaced from the longitudinal direction of the case.

Orientation disturbing sections 8R, 8S, and 8T are disposed at the left side plate 4 illustrated in (H) of this drawing. The orientation disturbing section 8R is a rib that has a semi-clrcular cross section and that extends from the bottom plate to near the center of the left side plate 4. The orientation disturbing section 8S is a rib that has a semi-circular cross section and that extends from the bottom plate to near the upper surface of the left side plate 4. The orientation disturbing section 8T is a rib that has a shape in which a cylinder having a circular cross section is connected to the left side plate 4 with a column having a rectangular cross section disposed therebetween and that extends from the bottom plate to near the upper surface of the left side plate 4. The long-fiber fillers attempt to flow into the orientation disturbing sections 8R, 8S, and 8T having the above-described shapes, so the fiber orientation of the long-fiber fillers in their surroundings is displaced from the longitudinal direction of the case.

Orientation disturbing sections 8U, 8V, and 8W are disposed at the upper surface of the left side plate 4 illustrated in (I) of this drawing. The orientation disturbing section 8U is a cylindrical boss that vertical extends from the upper surface. The orientation disturbing section 8V is an elongated cylindrical boss that vertical extends from the upper surface. The orientation disturbing section 8W is a tubular boss that vertically extends from the upper surface. The long-fiber fillers attempt to flow into the orientation disturbing sections 8U, 8V, and 8W having the above-described shapes, so the fiber orientation of the long-fiber fillers in their surroundings is displaced from the longitudinal direction of the case.

The orientation disturbing sections having various shapes illustrated above can displaced the fiber orientation of the long-fiber fillers around the locations where they are disposed. Thus the provision of an orientation disturbing section to a site where molding shrinkage caused by shrinkage factor is smaller than those of other sites, for example, a side plate of an injection molded article having an opening at a single side. In particular, a side plate of a case having a thick bottom plate enables molding shrinkage caused by an orientation factor to be larger than those of other sites, so balance in molding shrinkage among sites can be achieved.

Preferably, a plurality of orientation disturbing sections described above may be provided, and they may be disposed in the longitudinal direction of a long-type case. Although depending on the degree of shrinkage of the bottom plate, the provision of the plurality of orientation disturbing sections enables an orientation factor to be displaced so as to achieve better balance, so the use of the orientation factor can efficiency achieve balance in molding shrinkage among sites.

Next, a configuration of a magnetic sensor that includes an injection molded article as a case according to a second embodiment is described.

Fig. 4 is a schematic side view of a paper-currency identifying apparatus using a magnetic sensor 100.

A paper-currency identifying apparatus includes a paper-currency guide plate 102 and the magnetic sensor 100. The magnetic sensor 100 and the paper-currency guide plate 102 are arranged so as to face each other. Paper currency 101 is conveyed between the paper-currency guide plate 102 and the magnetic sensor 100. The direction in which the paper currency 101 is conveyed is perpendicular to the drawing. The magnetic sensor 100 is long in a direction perpendicular to the direction in which the paper currency 101 is conveyed. However, it is to be noted that paper currency may be conveyed while being skewed more or less. Therefore, the longitudinal direction of the magnetic sensor 100 is not always strictly orthogonal to the direction in which the paper currency 101 is conveyed.

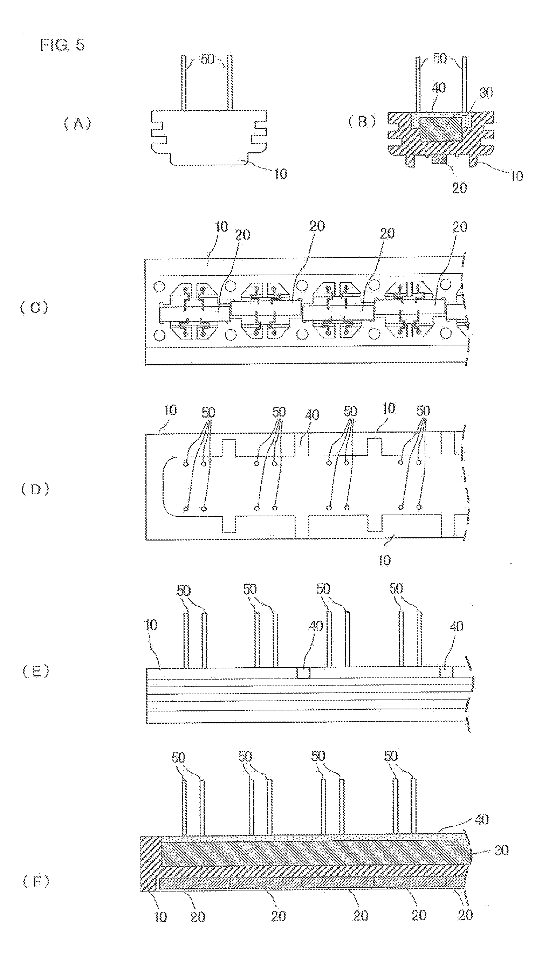

Fig. 5 is enlarged views of part of the magnetic sensor 100. (A) of this drawing is a front view, (B) of this drawing is a front cross-sectionai view, (C) of this drawing is a bottom view, (D) of this drawing is a top view. (E) of this drawing is a side view, and (F) of this drawing is a side cross-sectional view.

The magnetic sensor 100 includes a case 10, a plurality of MR elements 20, a long-type magnet 30, mold resin 40, and a plurality of terminal pins 50. Although not illustrated here, preferably, a metal cover that allows magnetic fields to be transmitted therethrough (e.g., made of aluminum) may be disposed on the lower surface of the case 10 and the metal cover may be connected to the ground with respect to a mounting board. The magneto-resistive elements according to the present invention are not limited to MR elements; Hall elements may also be used.

Each of the plurality of MR elements 20 is a four-terminal element and has a rectangular parallelepiped shape, and its longitudinal direction is the same as the longitudinal direction of the magnetic sensor 100. The long-type magnet 30 has a rectangular parallelepiped shape, and its longitudinal direction is the same as the longitudinal direction of the magnetic sensor 100. The mold resin 40 seals the long-type magnet 30 in the opening of the case 10. Each of the plurality of terminal pins 50 has a base end connected to one of the four terminal of one of the MR elements 20 with connection wiring disposed therebetween and a leading end projecting from the upper surface of the case 10.

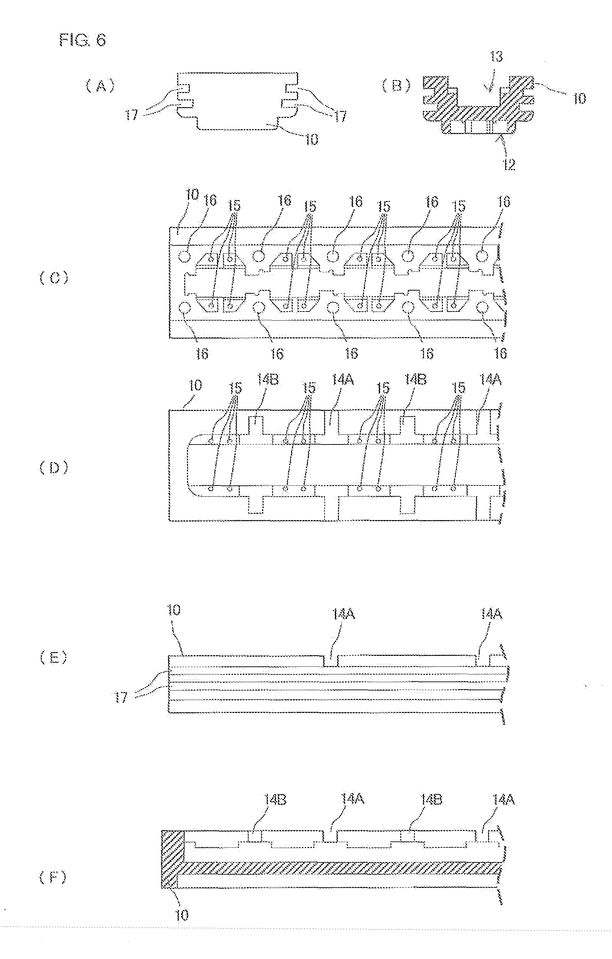

Fig. 6 is enlarged views of part of the case 10. (A) of this drawing is a front view, (B) of this drawing is a front cross-sectional view, (C) of this drawing is a bottom view, (D) of this drawing is a top view, (E) of this drawing is a side view, and (F) of this drawing is a side cross-sectional view.

The case 10 is an injection molded article formed by injection molding of resin material in which long-fiber fillers are distributed and is molded by injection of resin material into a die from a front plate side, which is the left-hand side illustrated in the illustration (C) to illustration (F). According, for the bottom plate, the right side plate, and the left side plate, the flow orientation of resin material is substantially along the longitudinal direction of the case 10 and the fiber orientation of the long-fiber fillers is also substantially along the longitudinal direction of the case 10. The bottom plate of the case 10 corresponds to the bottom portion, and the side plate of the case 10 corresponds to the side portion.

The case 10 is provided with an element accommodating section 12, a magnet accommodating section 13, a plurality of orientation disturbing sections 14A, a plurality of orientation disturbing sections 14B, a plurality of pin through-holes 15, a plurality of reduction holes 16, and a plurality of reduction grooves 17.

The element accommodating section 12 is a space that is used for accommodating the plurality of MR elements 20 and that is disposed in the lower surface of the case 10. The magnet accommodating section 13 is an opening space that is used for accommodating the long-type magnet 30 and the mold resin 40 and that is disposed in the upper surface of the case 10. The plurality of pin through-holes 15 are holes through which the respective terminal pins 50 pass. The plurality of reduction holes 16 are non-penetrating holes that are used for reducing the thickness. The plurality of reduction grooves 17 are grooves that are used for reducing the thickness and that are disposed on the right side and left side of the case 10.

The plurality of orientation disturbing sections 14A are grooves that are disposed at the upper surface of each of the left side plate and the right side plate, that each has a rectangular cross section in the thickness direction, and that extend along the thickness direction. The orientation disturbing sections 14B are cubic cuts disposed in the inner side of the opening of the case and in the upper surface side of the opening. The orientation disturbing sections 14A and 14B having the above-described shapes are arranged along the longitudinal direction of the case to and are depressed vertically from the upper surface, so the flow orientation of the long-fiber fillers in their surroundings is displaced from the longitudinal direction of the case. Because the plurality of orientation disturbing sections 14A and 148 are disposed vertically with respect to the thickness direction of the side plate, there is substantially no effect of suppressing an equivalent thickness of the side plate in the thickness direction in peripheral sites of the locations where they are disposed.

The reduction grooves 17 have an effect of suppressing an equivalent thickness of the side plate. Each of the reduction grooves 17 has a shape depressed in parallel with the injection direction over the entire length along the longitudinal direction of the case 10, so the fiber orientation of the long-fiber fillers in its surroundings is not substantially displaced from the longitudinal direction of the case and the long-fiber fillers are oriented along the longitudinal direction of the case.

The element accommodating section 12 and the plurality of reduction holes 16 have an effect of suppressing an equivalent thickness of the bottom plate. It is to be noted that they have a shape partially depressed along the longitudinal direction of the case 10, so the flow orientation of the long-fiber fliers around the bottom plate, where they are disposed, is displaced from the longitudinal direction of the case.

Accordingly, the thickness of the side plate is suppressed by the reduction grooves 17 and the flow orientation therein is displaced by the orientation disturbing sections 14A and 14B, whereas the thickness of the bottom plate is suppressed by the element accommodating section 12 and the reduction holes 16 and the flow orientation therein is displaced. Accordingly, the amount of molding shrinkage based on the shrinkage factor and the orientation factor for the side plate and the amount of molding shrinkage based on the shrinkage factor and the orientation factor for the bottom plate are balanced, and bow of the case 10 is decreased.

Next, a result of ascertaining molding shrinkage of a case having substantially the same outer shape as the case 10 using actual measurement and simulations is described.

The cases used in actual measurement and a simulation have dimensions below.

Total Length: 193 mm
Total Width: 15.7 mm
Total Height: 7.35 mm
First, the presence and absence of orientation disturbing sections was examined.
In a simulation, a case C1 that does not include reduction holes, reduction grooves, and orientation disturbing sections, a case C2 that includes reduction holes and reduction grooves and no orientation disturbing sections, and a case C3 that includes reduction holes, reduction grooves, and orientation disturbing sections were compared.
The settings of these cases are as follows:
Case C1: No Reduction Holes
   No Reduction Grooves
   No Orientation Disturbing Sections
Case C2: With Reduction Holes
   With Reduction Groove
   No. Orientation Disturbing Sections
Case C3: With Reduction Holes
   With Reduction Grooves
   With Orientation Disturbing Sections
   Lateral Groove Shape (Penetrating)
   17 × 2 rows
   Depth 0.5 mm
   Width 1.6 mm
Results of the simulation are as follows: for the case C1, the bottom plate was bowed concavely with respect to the bottom surface, and the amount of the bow in the location of the maximum deformation was 1.13 mm; for the case C2, the bottom plate was bowed concavely with respect to the bottom surface, and the amount of the bow in the location of the maximum deformation was 0.55 mm; and for the case C3, reversely, the bottom plate was bowed convexly with respect to the bottom surface, and the amount of the bow in the location of the maximum deformation was 0.40 mm. Accordingly, the results ascertained that a bias in a direction in which the bottom plate was bowed convexly with respect to the bottom surface was applied by the orientation disturbing sections.

Next, the depth of each of the orientation disturbing sections was examined.

In a simulation, comparison was made using orientation disturbing sections having different depths.
The settings of the cases are as follows:
Case C3: Described Above
Case C4: With Reduction Holes
   With Reduction Grooves
   With Orientation Disturbing Sections
   Lateral Groove Shape (Penetrating)
   17 × 2 rows
   Depth 1.0 mm
   Width 1.6 mm
Results of the simulation are as follows: for the case C3, the bottom plate was bowed convexly with respect to the bottom surface, and the amount of the bow in the location of the maximum deformation was 0.40 mm; and for the case C4, the bottom plate was bowed convexly with respect to the bottom surface, and the amount of the bow in the location of the maximum deformation was 1.1 mm. Accordingly, the results ascertained that a bias in a direction in which the bottom plate was bowed convexly with respect to the bottom surface varied with the depth of the orientation disturbing section; specifically, that bias increased with an increase in the depth and decreased with a decrease in the depth.

Next, the number of orientation disturbing sections was examined.

In a simulation, comparison was made using different numbers of orientation disturbing sections.
The settings of the cases are as follows:
Case C4: Described Above
Case C5: With Reduction Holes
   With Reduction Grooves
   With Orientation Disturbing Sections
   Lateral Groove Shape (penetrating)
   9 × 2 rows
   Depth 1.0mm
   Width 1.6 mm
Case C6: With Reduction Holes
   With Reduction Grooves
   With Orientation Disturbing Sections
   Lateral Groove Shape (Penetrating)
   5 × 2 rows
   Depth 1.0 mm
   Width 1.6 mm
Results of the simulation are as follows: for the case 04, the bottom plate was bowed convexly with respect to the bottom surface, and the amount of the bow in the location of the maximum deformation was 1.1 mm; for the case C5, the bottom plate was bowed convexly with respect to the bottom surface, and the amount of the bow in the location of the maximum deformation was 0.6 mm; and for the case C6, the bottom plate was bowed convexly with respect to the bottom surface, and the amount of the bow in the location of the maximum deformation was 0.5 mm. Accordingly, the results ascertained that a bias in a direction in which the bottom plate was bowed convexly with respect to the bottom surface varied with the number of orientation disturbing sections; specifically, that bias increased with an increase in the number and decreased with a decrease in the number.

Next, the shape of each of the orientation disturbing sections was examined.

In a simulation, comparison was made using orientation disturbing sections having different shapes.
The settings of the cases are as follows:
Case C4: Described Above
Case C7: With Reduction Holes
   With Reduction Grooves
   With Orientation Disturbing Sections
   Cut Shape (Non-Penetrating)
   9 × 2 rows
   Depth 1.0 mm
   Width 1.6 mm
Results of the simulation are as follows: for the case C4, the bottom plate was bowed convexly with respect to the bottom surface, and the amount of the bow in the location of the maximum deformation was 1.1 mm; and for the case C7, the bottom plate was bowed convexly with respect to the bottom surface, and the amount of the bow in the location of the maximum deformation was 0.05 mm. Accordingly, the results ascertained that a bias in a direction in which the bottom plate was bowed convexly with respect to the bottom surface varied with the shape of the orientation disturbing section; specifically, that bias was large for a penetrating-hole shape and small for a non-penetrating hole shape.

The above simulations ascertained that the orientation disturbing sections according to the present invention applied a bias in a direction in which the bottom plate was bowed convexly with respect to the bottom surface, and its degree was adjustable in accordance with the number of orientation disturbing sections or the shape or depth thereof.

Next, results of actual measurement are described.

In actual measurement, a situation where the case included orientation disturbing sections and a situation where the case included neither orientation disturbing sections nor reduction holes were compared. The number of reduction holes of the case was 36 in total, the number of orientation disturbing sections was 34 in total (the number of the orientation disturbing sections 14A was 16 and that of the orientation disturbing sections 148 was 18), and the depth of each of the orientation disturbing sections was 1,0 mm.

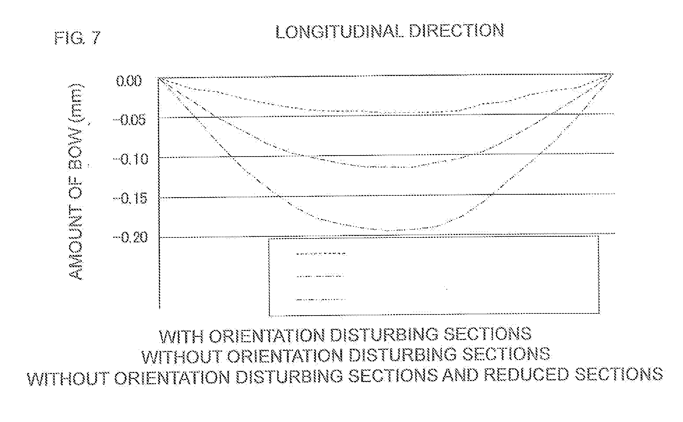

Fig. 7 illustrates measured values of the amount of bow of the case. In the drawing, the broken line indicates the values for the case including the orientation disturbing sections, the alternate long and short dashed line indicates those for the case including no orientation disturbing sections, and the chain double-dashed line indicates those for the case including neither reduction holes nor orientation disturbing sections.

As a result of the actual measurement, for the cases, when the opposite ends were maintained horizontally, the bottom plate was bowed convexly with respect to the bottom surface; the amount of the bow in the location of the maximum deformation was approximately 0.05 mm for the case including the orientation disturbing sections, approximately 0.13 mm for the case including no orientation disturbing sections, and approximately 0.20 mm for the case including neither orientation disturbing sections nor reduction holes. Accordingly, the results ascertained that the amount of bow could be decreased by the presence or absence of the orientation disturbing sections.

## Claims

1. An injection molded article formed by injection molding of resin material in which long-fiber fillers are distributed, the injection molded article having a case shape and including a bottom portion and a side portion,
wherein the side portion is provided with an orientation disturbing section for partially displacing orientation directions of the long-fiber fillers during injection molding.

2. The injection molded article according to Claim 1, wherein the thickness of the side portion is thinner than that of the bottom portion.

3. The injection molded article according to Claim 1 or 2, wherein the orientation disturbing section has a shape depressed partially in a vertical direction with respect to a mean orientation direction of the long-fiber fillers.

4. The injection molded article according to Claim 1 or 2, wherein the orientation disturbing section has a shape projecting partially in a vertical direction with respect to a mean orientation direction of the long-fiber fillers.

5. The injection molded article according to any one of Claims 1 to 4, wherein the bottom portion is provided with a reduced section depressed or projecting in a vertical direction with respect to a mean orientation direction of the long-fiber fillers.

6. A magnetic sensor comprising:
a case comprising an injection molded article according to any one of Claims 1 to 5;
a plurality of magnetoelectric transducer elements for sensing a change in magnetic field in their surroundings, the magnetoelectric transducer elements being provided to the bottom portion; and
a magnet for applying a magnetic field to the surroundings of the plurality of magneto-resistive elements, the magnet being accommodated in an opening of the case.
